# FASCICULE DE BREVET EUROPEEN

(11) **EP 3 900 059 B1**
(45) Date de publication et mention de la délivrance du brevet: **08.02.2023**
(21) Numéro de dépôt: 19848800.9
(22) Date de dépôt: 19.12.2019
(51) Int. Cl.: H01L 33/50

(54) **DISPOSITIF OPTOELECTRONIQUE COMPRENANT UNE MATRICE DE BLOCS PHOTOLUMINESCENTS ET SON PROCEDE DE FABRICATION**
OPTOELEKTRONISCHE VORRICHTUNG MIT EINER ANORDNUNG VON PHOTOLUMINESZENTEN BLÖCKEN UND VERFAHREN ZUR HERSTELLUNG DAVON
OPTOELECTRONIC DEVICE COMPRISING AN ARRAY OF PHOTOLUMINESCENT BLOCKS AND METHOD FOR THE PRODUCTION OF SAME

(30) Priorité: 20.12.2018 FR 1873474
(43) Date de publication de la demande: 27.10.2021
(73) Titulaire: Aledia, 38130 Echirolles (FR)
(72) Inventeur: GARONI, Eleonora, 38000 GRENOBLE (FR); LINCHENEAU, Christophe, 38000 GRENOBLE (FR); SCARINGELLA, Sylvia, 38330 MONTBONNOT-SAINT-MARTIN (FR)
(74) Mandataire: Cabinet Beaumont
(86) Numéro de dépôt international: PCT/FR2019/053223
(87) Numéro de publication internationale: WO 2020/128376

(56) Documents cités:
- WO-A1-2018/219199
- US-A1- 2014 124 802
- US-A1- 2014 131 748

## Description

La présente demande de brevet revendique la priorité de la demande de brevet français FR18/73474.

### Domaine technique

La présente invention concerne de façon générale les dispositifs optoélectroniques comprenant une matrice de blocs photoluminescents et leurs procédés de fabrication, et plus particulièrement les dispositifs optoélectroniques adaptés à afficher des images, notamment un écran d'affichage ou un dispositif de projection d'images.

### Technique antérieure

Un pixel d'une image correspond à l'élément unitaire de l'image affichée ou captée par le dispositif optoélectronique. Pour l'affichage d'images couleur, le dispositif optoélectronique comprend en général, pour l'affichage de chaque pixel de l'image, au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage du dispositif optoélectronique l'ensemble formé par les trois sous-pixels d'affichage utilisés pour l'affichage d'un pixel d'une image.

Chaque sous-pixel d'affichage peut comprendre une source lumineuse, par exemple une diode électroluminescente, recouverte d'un bloc photoluminescent adapté à convertir le rayonnement fourni par la diode électroluminescente en un rayonnement à la longueur d'onde souhaitée. Des blocs photoluminescents de types différents doivent donc être formés selon la disposition des sous-pixels d'affichage. Un exemple de procédé de formation des blocs photoluminescents consiste, pour chaque type de bloc photoluminescent, à déposer une couche de résine photosensible comprenant des particules photoluminescentes du type donné et à délimiter les blocs photoluminescents aux emplacements souhaités par des étapes de photolithogravure. Un inconvénient d'un tel procédé est que les étapes de photolithogravure de tous les types différents de blocs photoluminescents nécessitent les positionnements successifs de plusieurs masques. Toutefois, le positionnement précis d'un masque par rapport au dispositif optoélectronique peut être une opération difficile notamment en raison du fait que les résines chargées avec les particules photoluminescentes peuvent n'être qu'imparfaitement transparentes. Le document US 2014/131748 décrit un dispositif optoélectronique comprenant une zone photoluminescents hydrophiles comprenant des particules photoluminescentes hydrophiles recouvrant des premières zones du support.

### Résumé de l'invention

Ainsi, un objet d'un mode de réalisation est de pallier au moins en partie les inconvénients des dispositifs optoélectroniques comprenant une matrice de blocs photoluminescents décrits précédemment.

Un autre objet d'un mode de réalisation est de simplifier le procédé de fabrication du dispositif optoélectronique.

Un autre objet d'un mode de réalisation est que le procédé de fabrication du dispositif optoélectronique ne comprend pas plusieurs étapes successives de positionnement de masques.

Un autre objet d'un mode de réalisation est que les dispositifs optoélectroniques puissent être fabriqués à une échelle industrielle et à bas coût.

Un mode de réalisation prévoit un dispositif optoélectronique comprenant un support, au moins des blocs photoluminescents hydrophiles comprenant des particules photoluminescentes hydrophiles recouvrant des premières zones du support et des blocs photoluminescents hydrophobes comprenant des particules photoluminescentes hydrophobes recouvrant des deuxièmes zones du support, les blocs photoluminescents hydrophiles étant au contact d'un matériau hydrophile aux premières zones et les blocs photoluminescents hydrophobes étant au contact d'un matériau hydrophobe aux deuxièmes zones.

Un mode de réalisation prévoit également un procédé de fabrication d'un dispositif optoélectronique comprenant la formation, sur un support, au moins de blocs photoluminescents hydrophiles comprenant des particules photoluminescentes hydrophiles recouvrant des premières zones du support et de blocs photoluminescents hydrophobes comprenant des particules photoluminescentes hydrophobes recouvrant des deuxièmes zones du support, les blocs photoluminescents hydrophiles étant au contact d'un matériau hydrophile aux premières zones et les blocs photoluminescents hydrophobes étant au contact d'un matériau hydrophobe aux deuxièmes zones.

Selon un mode de réalisation, chaque bloc photoluminescent hydrophile comprend au moins une monocouche desdites particules photoluminescentes hydrophiles.

Selon un mode de réalisation, chaque bloc photoluminescent hydrophobe comprend au moins une monocouche desdites particules photoluminescentes hydrophobes.

Selon un mode de réalisation, chaque bloc photoluminescent hydrophile comprend une matrice hydrophile dans laquelle sont dispersées les particules photoluminescentes hydrophiles.

Selon un mode de réalisation, chaque bloc photoluminescent hydrophobe comprend une matrice hydrophobe dans laquelle sont dispersées les particules photoluminescentes hydrophobes.

Selon un mode de réalisation, le matériau hydrophile comprend des premiers ligands hydrophiles, comprenant chacun une chaîne hydrophile, un premier groupement à une première extrémité de la chaîne hydrophile, fixé à un groupe hydroxy en surface du support, et un deuxième groupement à une deuxième extrémité de la chaîne hydrophile, opposée à la première extrémité, au contact de l'un des blocs photoluminescents hydrophiles.

Selon un mode de réalisation, les deuxièmes groupements sont fixés à desdites particules photoluminescentes hydrophiles.

Selon un mode de réalisation, chaque bloc photoluminescent hydrophile comprend un empilement de couches des particules photoluminescentes hydrophiles et des deuxièmes ligands hydrophiles fixés à des particules photoluminescentes hydrophiles de couches différentes.

Selon un mode de réalisation, le matériau hydrophobe comprend des premiers ligands hydrophobes, comprenant chacun une chaîne hydrophobe, un troisième groupement à une troisième extrémité de la chaîne hydrophobe, fixé à un groupe hydroxy en surface du support, et un quatrième groupement à une quatrième extrémité de la chaîne hydrophobe au contact de l'un des blocs photoluminescents hydrophobes.

Selon un mode de réalisation, les quatrièmes groupements sont fixés à desdites particules photoluminescentes hydrophobes.

Selon un mode de réalisation, chaque bloc photoluminescent hydrophobe comprend un empilement de couches des particules photoluminescentes hydrophobes et des deuxièmes ligands hydrophobes fixés à des particules photoluminescentes hydrophobes de couches différentes

Selon un mode de réalisation, le dispositif comprend des diodes électroluminescentes recouvertes par les blocs photoluminescents hydrophiles et hydrophobes.

Selon un mode de réalisation, le procédé comprend pour la formation des blocs photoluminescents hydrophiles et hydrophobes une seule étape d'exposition du support à un rayonnement électromagnétique au travers d'un masque.

Selon un mode de réalisation, le procédé comprend des étapes de formation de groupes hydroxy aux deuxièmes emplacements, d'application d'une première solution contenant les premiers ligands hydrophobes sur les premières et deuxièmes zones, de formation de groupes hydroxy aux deuxièmes emplacements, d'application d'une deuxième solution contenant les premiers ligands hydrophiles sur les premières et deuxièmes zones, d'application d'une troisième solution contenant les particules photoluminescentes hydrophiles sur les premières et deuxièmes zones et d'application d'une quatrième solution contenant les particules photoluminescentes hydrophiles sur les premières et deuxièmes zones.

Selon un mode de réalisation faisant pas partie l'invention, l'étape de formation de groupes hydroxy aux deuxièmes emplacements comprend l'exposition du support à un rayonnement électromagnétique en l'absence de masque.

Selon un mode de réalisation, le procédé comprend des étapes de formation de groupes hydroxy aux premiers emplacements, d'application d'une quatrième solution contenant des précurseurs de la matrice hydrophile et les particules photoluminescentes hydrophiles, de formation de la matrice hydrophile dans laquelle sont dispersées les particules photoluminescentes hydrophiles, d'application d'une cinquième solution contenant des précurseurs de la matrice hydrophobe et les particules photoluminescentes hydrophobes, et de formation de la matrice hydrophobe dans laquelle sont dispersées les particules photoluminescentes hydrophobes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique ;
la figure 2 illustre une étape d'un mode de réalisation d'un procédé de fabrication du dispositif optoélectronique représenté en figure 1 ;
la figure 3 illustre une autre étape du procédé de fabrication ;
la figure 4 illustre une autre étape du procédé de fabrication ;
la figure 5 illustre une autre étape du procédé de fabrication ;
la figure 6 illustre une autre étape du procédé de fabrication ;
la figure 7 illustre une autre étape du procédé de fabrication ;
la figure 8 illustre une autre étape du procédé de fabrication ;
la figure 9 illustre une autre étape du procédé de fabrication ;
la figure 10 illustre une autre étape du procédé de fabrication ;
la figure 11 illustre une autre étape du procédé de fabrication ;
la figure 12 illustre une autre étape du procédé de fabrication ;
la figure 13 est une vue en coupe, partielle et schématique, d'un autre mode de réalisation d'un dispositif optoélectronique ;
la figure 14 est une vue en coupe, partielle et schématique, d'un autre mode de réalisation d'un dispositif optoélectronique ;
la figure 15 illustre une étape successive d'un mode de réalisation d'un procédé de fabrication du dispositif optoélectronique représenté en figure 14 ;
la figure 16 illustre une autre étape du procédé de fabrication ; et
la figure 17 illustre une autre étape du procédé de fabrication.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et sont détaillés. Sauf précision contraire, les expressions "environ", "approximativement", "sensiblement", et "de l'ordre de" signifient à 10 % près, de préférence à 5 % près.

Le terme "particule" tel qu'utilisé dans le cadre de la présente demande doit être compris dans un sens large et correspond non seulement à des particules compactes ayant plus ou moins une forme sphérique mais aussi à des particules anguleuses, des particules aplaties, des particules en forme de flocons, des particules en forme de fibres, ou des particules fibreuses, etc. On comprendra que la "taille" des particules dans le cadre de la présente invention signifie la plus petite dimension transversale des particules. A titre d'exemple, dans le cas de particules en forme de fibres, la taille des particules correspond au diamètre des fibres. On entend par particules d'un matériau les particules prises individuellement (c'est-à-dire les éléments unitaires du matériau) sachant que le matériau peut se présenter sous la forme d'agglomérats de particules.

Par le terme "taille moyenne", on entend selon la présente invention la taille de la particule qui est supérieure à la taille de 50 % en volume des particules et inférieure à la taille de 50 % en volume des particules d'une distribution de particules. Ceci correspond au d50. La granulométrie des particules peut être mesurée par granulométrie laser en utilisant, par exemple, un Malvern Mastersizer 2000.

Dans la suite de la description, on considère un premier matériau pour lequel une goutte d'une solution liquide sur une couche du premier matériau présente un premier angle de contact statique et un deuxième matériau pour lequel une goutte de la solution liquide sur une couche du deuxième matériau présente un deuxième angle de contact statique, le premier angle de contact statique étant supérieur au deuxième angle de contact statique d'au moins 30 degrés, de préférence d'au moins 40 degrés, plus préférentiellement d'au moins 50 degrés. Le premier matériau est dit plus attractif pour la solution liquide que le deuxième matériau. Dans la suite de la description, on appelle "matériau attractif pour une solution liquide" un matériau pour lequel l'angle de contact statique d'une goutte de la solution liquide sur le matériau est inférieur à 90° et "matériau répulsif pour une solution liquide" un matériau pour lequel l'angle de contact statique d'une goutte de la solution liquide sur le matériau est supérieur à 90°. De façon générale, dans le cas d'une solution aqueuse, le matériau attractif est appelé matériau hydrophile et le matériau répulsif est appelé matériau hydrophobe. Toutefois, dans la suite de la description, les adjectifs hydrophile et hydrophobe sont utilisés de façon plus générale pour des raisons de simplicité. En particulier, lorsqu'un premier matériau est dit hydrophile et qu'un deuxième matériau est dit hydrophobe, cela signifie simplement que le premier matériau est plus attractif que le deuxième matériau pour n'importe quelle solution liquide, notamment une solution liquide non aqueuse, et donc que l'angle de contact statique de la solution liquide sur une couche du premier matériau est supérieur à l'angle de contact statique de la solution liquide sur une couche du deuxième matériau d'au moins 30 degrés, de préférence d'au moins 40 degrés, plus préférentiellement d'au moins 50 degrés. La mesure de l'angle de contact peut être réalisée en utilisant l'appareil de mesure commercialisé par la société GBX sous l'appellation Digidrop - MCAT. La mesure comprend le dépôt d'une goutte de la solution liquide considérée de 2 µl à 10 µl sur une surface du matériau à étudier, l'acquisition d'une image de la goutte par un dispositif d'acquisition d'images et la détermination de l'angle de contact par une analyse par ordinateur de l'image acquise.

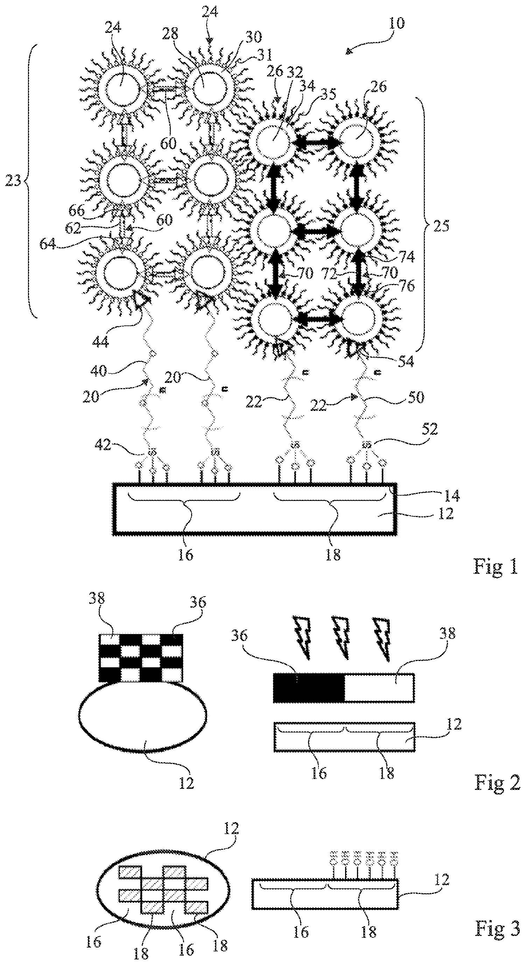

La figure 1 est une vue en coupe, partielle et schématique, d'un dispositif optoélectronique 10. Le dispositif optoélectronique 10 comprend, de bas en haut en figure 1 :
- un support 12 ayant une face supérieure 14 comprenant des premières zones 16 et des deuxièmes zones 18, une seule première zone 16 et une seule deuxième zone 18 étant représentées en figure 1 ;
- des premiers ligands hydrophiles 20 fixés aux premières zones 16 de la face supérieure 14 ;
- des premiers ligands hydrophobes 22 fixés aux deuxièmes zones 18 de la face supérieure 14 ;
- des premiers blocs photoluminescents 23 comprenant des premières particules photoluminescentes 24, réparties selon une rangée de premières particules photoluminescentes 24 ou en un empilement d'au moins deux rangées de premières particules photoluminescentes 24, un bloc 23 de trois rangées de premières particules photoluminescentes 24 étant représenté en figure 1, les premières particules photoluminescentes 24 de la première rangée étant fixées aux ligands hydrophiles 20, les premières particules photoluminescentes 24 des autres rangées étant reliées à d'autres premières particules photoluminescentes 24, éventuellement par des deuxièmes ligands hydrophiles 60 ; et
- des deuxièmes blocs photoluminescents 25 comprenant des deuxièmes particules photoluminescentes 26, réparties selon une rangée de deuxièmes particules photoluminescentes 26 ou en un empilement d'au moins deux rangées de deuxièmes particules photoluminescentes 26, un bloc 25 de trois rangées de deuxièmes particules photoluminescentes 26 étant représenté en figure 1, les deuxièmes particules photoluminescentes 26 de la première rangée étant fixées au ligands hydrophobes 22, les deuxièmes particules photoluminescentes 26 des autres rangées étant reliées à d'autres deuxièmes particules photoluminescentes 26, éventuellement par des deuxièmes ligands hydrophobes 70.

Le dispositif optoélectronique 10 peut en outre comprendre une couche d'encapsulation, non représentée, isolante électriquement et recouvrant l'ensemble de la structure qui recouvre les blocs photoluminescents 23, 25. La couche d'encapsulation peut comprendre une matrice transparente aux rayonnements émis par les blocs photoluminescents 23, 25. Il s'agit par exemple d'une matrice en polymère, éventuellement photosensible, notamment en polymère acrylate ou siloxane, par exemple en poly(méthacrylate de méthyle) (PMMA), une matrice en silicone, ou une matrice en dioxyde de silicium formé notamment par un procédé sol-gel. A titre de variante, la couche d'encapsulation peut être formée par un procédé de dépôt de couches minces atomiques (ALD, sigle anglais pour Atomic Layer Déposition). Des particules d'oxyde de titane (TiO₂) peuvent être dispersées dans la matrice de façon à diffuser les rayonnements émis par les blocs photoluminescents 23, 25. A titre de variante, une couche d'alumine (Al₂O₃) ou d'un mélange Al₂O₃/TiO₂ peut être déposée comme protection de la matrice ou à la place de celle-ci.

Le support 12 correspond à une couche du dispositif optoélectronique 10. Selon un mode de réalisation, le dispositif optoélectronique 10 comprend une matrice de diodes électroluminescentes et le support 12 correspond à une couche diélectrique recouvrant les diodes électroluminescentes et étant au moins en partie transparente au rayonnement émis par les diodes électroluminescentes. Les diodes électroluminescentes peuvent être des diodes électroluminescentes planaires dans lesquelles les diodes électroluminescentes sont formées par un empilement de couches semiconductrices sensiblement planes. Les diodes électroluminescentes peuvent être des diodes électroluminescentes tridimensionnelles dans lesquelles la couche active de chaque diode électroluminescente est formée sur un élément semiconducteur tridimensionnel, par exemple un microfil, un nanofil, un élément conique, notamment une pyramide, ou un élément tronconique.

Selon un mode de réalisation, chaque bloc photoluminescent 23, 25 est situé en vis-à-vis d'une diode électroluminescente et forme un sous-pixel d'affichage avec cette diode électroluminescente. Chaque bloc photoluminescent 23, 25 comprend des luminophores adaptés, lorsqu'ils sont excités par la lumière émis par la diode électroluminescente LED associée, à émettre de la lumière à une longueur d'onde différente de la longueur d'onde de la lumière émise par la diode électroluminescente associée. Selon un mode de réalisation, chaque pixel d'affichage comprend au moins deux types de blocs photoluminescents 23, 25. Le bloc photoluminescent 23 du premier type est adapté à convertir le rayonnement fourni par les diodes électroluminescentes en un premier rayonnement à une première longueur d'onde et le bloc photoluminescent 25 du deuxième type est adapté à convertir le rayonnement fourni par les diodes électroluminescentes en un deuxième rayonnement à une deuxième longueur d'onde.

Selon un mode de réalisation, la première longueur d'onde correspond à de la lumière verte et est dans la plage de 510 nm à 570 nm. Selon un mode de réalisation, la deuxième longueur d'onde correspond à de la lumière rouge et est dans la plage de 600 nm à 720 nm. Inversement, la première longueur d'onde peut correspondre à de la lumière rouge et la deuxième longueur d'onde peut correspondre à de la lumière verte. Les diodes électroluminescentes LED sont par exemple adaptées à émettre un rayonnement dont la longueur d'onde est dans la gamme allant de 300 nm à 500 nm, ou de préférence de 400 nm à 480 nm.

Chaque première particule photoluminescente 24 comprend un coeur 28 d'un premier matériau photoluminescent entourée par une première coque 30. Des premiers agents de surface 31 peuvent être présents en surface de chaque première coque 30. Chaque deuxième particule photoluminescente 26 comprend un coeur 32 d'un deuxième matériau photoluminescent entourée par une deuxième coque 34. Des deuxièmes agents de surface 35 peuvent être présents en surface de chaque deuxième coque 34. Chaque coque peut avoir une composition uniforme ou comprendre deux ou plus de deux couches sensiblement concentriques de compositions différentes.

Les dimensions des coeurs 28, 32 dépendent notamment de la nature des premiers et deuxièmes matériaux photoluminescents. Le premier matériau photoluminescent et le deuxième matériau photoluminescent peuvent être chacun indépendamment un aluminate, un silicate, un nitrure, un fluorure ou un sulfure. La taille moyenne des premières ou deuxièmes particules de tels matériaux photoluminescents est comprise entre 1 µm et 20 µm, de préférence entre 1 µm et 10 µm, encore plus préférentiellement entre 1 µm et 8 µm.

Selon un mode de réalisation, le premier matériau photoluminescent et le deuxième matériau photoluminescent peuvent être chacun indépendamment un aluminate, notamment un grenat d'aluminium et d'yttrium selon la formule (1) suivante :

(Y₃₋ₓR1ₓ) (Al_{5-y}R2_{y}) O₁₂

où R1 et R2 sont indépendamment choisis parmi les éléments comprenant les terres rares, les alcalino-terreux et les métaux de transition et x et y varient chacun et indépendamment de 0 à 1,5, de préférence de 0 à 1. De préférence, R1 et R2 sont indépendamment choisis parmi le groupe comprenant le cérium, le samarium, le gadolinium, le silicium, le baryum, le terbium, le strontium, le chrome, le praséodyme, le gallium, l'europium, l'erbium ou l'ytterbium.

A titre d'exemple de nitrures absorbant et émettant de la lumière dans les gammes de longueurs d'onde souhaitées, on peut citer CaAlSiN₃:Eu, (Ca,Sr)AlSiN₃:Eu, Ca₂Si₃N₈:Eu ou (Ca,Sr)Si₅N₈:Eu.

A titre d'exemple de fluorures absorbant et émettant de la lumière dans les gammes de longueurs d'onde souhaitées, on peut citer les fluorures de formule K₂MF₆:Mn (où M peut être Si, Ge, Sn ou Ti), NaYF₄, NaLnF₄ (où Ln est un lanthanide, notamment Ce, Sm, Pr, Eu, Tb), Ln¹₁₋ₓLn²ₓF₃ (où Ln¹ et Ln² sont des terres rares) ainsi que leurs analogues dopés, par exemple NaYF₄:Ln¹/Ln² et leurs analogues ayant une structure du type coeur@coque, notamment NaYF₄:Ln¹/Ln²@NaYF₄, Ln¹₁₋ₓLn²ₓF₃@NaYF₄.

A titre d'exemple de sulfures absorbant et émettant de la lumière dans les gammes de longueurs d'onde souhaitées, on peut citer CaS:Eu, SrCa:Eu, (Sr,Ca)S:Eu et SrGa₂S₄:Eu.

A titre d'exemple d'aluminate absorbant et émettant de la lumière dans les gammes de longueurs d'onde souhaitées, on peut citer Y₃Al₅O₁₂:Ce (également appelé YAG:Ce ou YAG:Ce³⁺), (Y,Gd)₃Al₅O₁₂:Ce, Tb₃Al₅O₁₂, (Y,Tb)₃Al₅O₁₂, Lu₃Al₅O₁₂:Ce et Y₃(Al, Ga)₅O₁₂.

A titre d'exemple de silicates absorbant et émettant de la lumière dans les gammes de longueurs d'onde souhaitées, on peut citer (Sr,Ba)₃SiO₄:Eu, Sr₂SiO₄:Eu, Ba₂SiO₄:Eu, Ca₂SiO₄:Eu, Ca₃SiO₅:Eu et Sr₃SiO₅:Eu.

Selon un mode de réalisation, chaque coeur 28 ou 32 est de taille nanométrique et est en un matériau semiconducteur. Les coeurs 28 ou 32 sont alors appelés nanocristaux semiconducteurs. Selon un mode de réalisation, la taille moyenne de chaque nanocristal semiconducteur est dans la plage de 0,5 nm à 1000 nm, de préférence de 0,5 nm à 500 nm, encore plus préférentiellement de 1 nm à 100 nm, notamment de 2 nm à 30 nm. Pour des dimensions inférieures à 50 nm, les propriétés de photoconversion des nanocristaux semiconducteurs 28, 32 dépendent essentiellement de phénomènes de confinement quantique. Les nanocristaux semiconducteurs 28, 32 correspondent alors à des boîtes quantiques. Selon un mode de réalisation, le matériau semiconducteur de chaque nanocristal semiconducteur 28, 32 est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les pérovskites du type PbScX₃, où X est un atome d'halogène, notamment l'iode (I), le brome (Br) ou le chlore (Cl), le CuInS₂, le CuInSe₂, le ZnInS, les matériaux précédents dopés avec des métaux de transition M (où M correspond à Mn, Ag, As, Sb...), notamment Cdₓ₋ₙSeMₙ, CdSe:M, InP:M, ZnS:M, ZnInS:M, CuInS₂:M, CuInSe₂:M en particulier dopées avec Mn et Ag, les systèmes ternaires tels que InPZn, les systèmes quaternaires tels que InPZnS, InPZnAs (Sb, Ln), leur dérivés dopés comme par exemple InPZn:M et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi - Rapid Research Letters (RRL) Volume 8, No. 4, pages 349-352, avril 2014. Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

Les coques 30, 34 peuvent être en ZnS, ZnSe, CdS ou CdSe. L'épaisseur de chaque coque 30, 34 peut être comprise entre 1 nm et 20 nm. Comme cela a été décrit précédemment, chaque coque peut avoir une composition uniforme ou comprendre deux ou plus de deux couches sensiblement concentriques de compositions différentes, par exemple CdSe/CdS/ZnS ou InP/ZnSe/ZnS. Selon un mode de réalisation, la variation entre la composition du coeur et la composition de la coque est réalisée de façon graduelle, le nanocristal semiconducteur étant par exemple selon la formule Cdₙ₋ₓSe_{m-y}ZnₓS_{y} avec x variant graduellement de 0 au centre du coeur à n dans la coque et y variant de 0 au centre du coeur à m dans la coque.

Selon un mode de réalisation, les premières et/ou deuxièmes particules photoluminescentes comprennent une coque externe encapsulante en oxyde, comme par exemple SiO₂ ou TiO₂, contenant un, deux ou plus de deux nanocristaux du même type que ceux décrits précédemment.

Les premières particules photoluminescentes 24 sont hydrophiles. Selon un mode de réalisation, le caractère hydrophile est au moins en partie dû aux premiers agents de surface 31 en surface de la coque 30 de chaque première particule photoluminescente 24. Selon un mode de réalisation, les premiers agents de surface 31 peuvent correspondre à des dérivés de polyéthylène glycol, des dérivés de carboxylate, notamment l'acide lipoïque, des dérivés d'acide aminés, notamment la cystéine ou la pénicillamine, les saccharides ou les saccharides modifiées avec des groupes thiols et/ou amine. Des exemples de premiers agents de surface sont l'acide lipoïque de formule C₃H₁₄O₂S₂ et l'acide dihydrolipoïque de formule C₈H₁₆O₂S₂. Les deuxièmes particules photoluminescentes 26 sont hydrophobes. Selon un mode de réalisation, le caractère hydrophobe est au moins en partie dû aux deuxièmes agents de surface 35 présents en surface de la coque 34 de chaque deuxième particule photoluminescente 26. Selon un mode de réalisation, les deuxièmes agents de surface 35 peuvent correspondre à des ligands hydrophobes basés sur des chaînes aliphatiques saturées ou insaturées, ramifiées ou non, ou basés sur des chaînes polyaromatiques. De manière générale, il peut s'agir de ligands avec une chaîne hydrophobe et une tête d'ancrage, par exemple de formule générale R-(CH₂)ₙ-CH₃ ou R-(CH₂)ₙ-(CH=CH)ₘ-CH₃ ou CH₃(CH₂)ₙ-CR(CH₂)ₘCH₃)-(CH₂)ₚCH₃ avec R égal à COO⁻, NH₂, SH, P ou PO₃. Des exemples sont l'octadécylamine (ODA) de formule CH₃(CH₂)₁₇NH₂, l'oléamine (OLA) de formule CH₃(CH₂)₇CH=CH(CH₂)₇CH₂NH₂, l'acide oléique (OA) de formule CH₃(CH₂)₇CH=CH(CH₂)₇COOH, l'hexadécylamine (HDA) de formule CH₃(CH₂)₁₅NH₂, le trioctylphosphine (TOP) de formule (CH₃(CH₂)₇)₃P, l'oxyde de trioctylphosphine (TOPO) de formule (CH₃(CH₂)₇)₃PO, et le dodécanethiol (DDT) de formule CH₃(CH₂)₁₁SH.

Chaque premier ligand hydrophile 20 correspond à une molécule qui est fixée au support 12 et à au moins une première particule photoluminescente 24. Chaque molécule du ligand hydrophile 20 comprend une chaîne centrale hydrophile 40, un premier groupement 42, capable d'interagir avec le support 12, à une première extrémité de la chaîne 40 et un deuxième groupement 44, capable d'interagir avec les premières particules photoluminescentes 24, à une deuxième extrémité de la chaîne 40 opposée à la première extrémité.

La chaîne centrale hydrophile 40, linéaire ou ramifiée, peut comprendre une chaîne principale en un polyacrylate, un polyéthylène glycol, un polyamide, une chaîne peptidique ou polypeptidique, un saccharide ou un polysaccharide. Des groupes hydrophiles peuvent être reliés à la chaîne principale pour augmenter le caractère hydrophile, par exemple des groupes hydroxy, cétone, ammonium, carboxylate, phosphate, phosphite, phosphonate, sulfate, amide, et amine. C'est essentiellement la chaîne 40 qui donne le caractère hydrophile au ligand 20.

Le premier groupement 42 est un groupement adapté à réagir avec au moins un groupe hydroxy, par exemple pour former une liaison covalente avec le support 12. Selon un mode de réalisation, le premier groupement 42 comprend, avant la fixation au support 12, au moins un groupe chimique fonctionnel éther de silyle, comme un tris-alkoxy silane, ou un groupe alkoxy de formule -OCₙH₂ₙ₊₁ où n est supérieur à 1, de préférence entre 1 et 5, par exemple le triméthoxysilane, triéthoxysilane, tripropoxysilane, triisopropoxysilane et le tripopoxysilane. Selon un mode de réalisation, le premier groupement 42, avant la réaction avec des groupes hydroxy, est le -Si(CH₃O)₃.

Le deuxième groupement 44 est un groupement adapté à se fixer à au moins une première particule photoluminescente 24, par exemple à la coque 30 ou aux agents de surface 31 recouvrant la coque 30 de la première particule photoluminescente 24. La liaison entre le deuxième groupement 44 et la première particule photoluminescente 24 ou les agents de surface 31 recouvrant la première particule photoluminescente 24 peut être une liaison covalente, une liaison organométallique ou une interaction faible. Le deuxième groupement 44 peut comprendre, avant la liaison à la première particule photoluminescente 24, au moins un groupe chimique fonctionnel correspondant à un groupe amine, carboxylique, thiol, dithiol, trithiol, pyridinyle, phosphine, oxyde de phosphine (notamment lorsque la première particule correspond à une boîte quantique), phosphonate ou phosphite. Lorsque la surface des premières particules photoluminescentes 24 est chargée négativement, le deuxième groupement 44 peut en outre comprendre, avant la liaison à la première particule photoluminescente 24, au moins un groupe chargé positivement, comme un groupe ammonium ou pyridinium.

Des exemples de ligands hydrophiles 20 ont une formule générale dérivée de la formule chimique générale R(OCH₂-CH₂)ₙSi(OCₘH₂ₘ₊₁)₃ où R est l'un des deuxièmes groupements décrits précédemment, avant la liaison à la première particule photoluminescente 24, notamment le mercapto-mPEG5K-silane de formule SH-CH₂O(CH₂CH₂O)ₙCH₂CONHCH₂CH₂CH₂Si(OCH₂CH₃)₃ ou l'amino-mPEG5K-silane de formule NH₂-CH₂O(CH₂CH₂O)ₙCH₂CONHCH₂CH₂CH₂Si(OCH₂CH₃)₃.

Chaque premier ligand hydrophobe 22 correspond à une molécule qui est fixée au support 12 et à au moins une deuxième particule photoluminescente 26. Chaque molécule du ligand hydrophobe 22 comprend une chaîne centrale hydrophobe 50, un troisième groupement 52, capable d'interagir avec le support 12, à une première extrémité de la chaîne 50 et un quatrième groupement 54, capable d'interagir avec les deuxièmes particules photoluminescentes 26, à une deuxième extrémité de la chaîne 50 opposée à la première extrémité. La chaîne hydrophobe 50 peut comprendre une chaîne principale carbonée comprenant par exemple de 2 à 20 atomes de carbone. Des groupes alkyles peuvent être reliés à la chaîne principale pour augmenter le caractère hydrophobe. C'est essentiellement la chaîne 50 qui donne le caractère hydrophobe au ligand 22. Le troisième groupement 52 est un groupement adapté à réagir avec au moins un groupe hydroxy. Le troisième groupement 52 peut correspondre à l'un des exemples décrits précédemment pour le premier groupement 42. Le quatrième groupement 54 est un groupement adapté à se fixer à au moins une deuxième particule photoluminescente 26. La liaison entre le quatrième groupement 54 et la deuxième particule photoluminescente 26 ou les agents de surface 35 recouvrant la deuxième particule photoluminescente 26 peut être une liaison covalente, une liaison organométallique ou une interaction faible. Le quatrième groupement 54 peut comprendre au moins un groupe chimique fonctionnel correspondant à un groupe amine, phosphine, acide carboxylique, thiol, dithiol, trithiol, pyridinyle, phosphine, oxyde de phosphine (notamment lorsque la première particule correspond à une boîte quantique), phosphonate, phosphite ou alkyle. Lorsque la surface des deuxièmes particules photoluminescentes 26 est chargée négativement, le quatrième groupement 54 peut en outre comprendre, avant la liaison à la première particule photoluminescente 26, au moins un groupe chargé positivement, comme un groupe ammonium ou pyridinium.

Des exemples de ligands hydrophobes 22 sont le 3-aminopropyl (triméthoxysilane) de formule H₂N(CH₂)₃Si(OCH₃)₃, le 3-mercaptopropyl(triméthoxysilane) de formule HS (CH₂)₃Si(OCH₃)₃, le 3-aminopropyl(triéthoxysilane) de formule H₂N(CH₂)₃Si(OCH₂CH₃)₃, le 3-mercaptopropyl(triéthoxysilane) de formule HS(CH₂)₃Si(OCH₂CH₃)₃, le 4-aminobutyl(triméthoxysilane) de formule H₂N(CH₂)₄Si(OCH₃)₃ et le 4-mercaptobutyl(triméthoxysilane) de formule HS (CH₂)₄Si(OCH₃)₃.

Chaque deuxième ligand hydrophile 60 comprend une chaîne centrale 62, un cinquième groupement 64 à une première extrémité de la chaîne 62 et un sixième groupement 66 à une deuxième extrémité de la chaîne 62, opposée à la première extrémité. La chaîne centrale 62 peut avoir la même structure que la chaîne 20 décrite précédemment.

Chaque groupement 64, 66 est adapté à se lier avec une première particule photoluminescente 24. Chaque groupement 64, 66 peut correspondre au deuxième groupement 44 décrit précédemment. En outre, les ligands 60 peuvent correspondre à du poly(éthylène glycol)diamines ayant des unités-(OCH₂CH₂O)ₙ- où n est supérieur à 1, de préférence compris entre 2 et 5 ou du poly(éthylène glycol)dithiols ayant des unités -(OCH₂CH₂O) ₙ où n est supérieur à 1, de préférence compris entre 2 et 5.

Chaque deuxième ligand hydrophobe 70 comprend une chaîne centrale 72, un septième groupement 74 à une première extrémité de la chaîne 72 et un huitième groupement 76 à une deuxième extrémité de la chaîne 72, opposée à la première extrémité. La chaîne centrale 72 peut avoir la même structure que la chaîne 50 décrite précédemment. La chaîne centrale 72 peut en outre correspondre à une chaîne stéroïdique, au polycyclohexane, à l'adamantane et aux bases de Tröger qui sont des composés rigides et hydrophobes, ce qui permet de maintenir une distance stable entre les couches de particules photoluminescentes 26 et entre les particules photoluminescentes 26 elles-mêmes. Chaque groupement 74, 76 est adapté à se lier avec une deuxième particule photoluminescente 26. Chaque groupement 74, 76 peut correspondre au quatrième groupement 54 décrit précédemment. Les ligands 70 peuvent correspondre à des diamines, comme le 1,n-hexaméthylènediamine où n est supérieur à 2, de préférence compris entre 4 et 10 ; des dithiols, comme le 1,n-hexanedithiol où n est supérieur à 2, de préférence compris entre 4 et 10.

Les figures 2 à 12 représentent chacune, en partie gauche, une vue en perspective partielle et schématique du dispositif optoélectronique, et, en partie droite, une vue en coupe partielle du dispositif optoélectronique de la partie gauche, à des étapes successives d'un mode de réalisation du procédé de fabrication du dispositif optoélectronique 10 représenté en figure 1.

La figure 2 illustre une étape d'exposition du support 12 à un rayonnement électromagnétique au travers d'un masque 36 comprenant des ouvertures 38 de façon à exposer seulement les deuxièmes zones 18 au rayonnement électromagnétique. Le masque 36 est maintenu à distance du support 12 pendant l'étape d'exposition. Selon un mode de réalisation, le rayonnement électromagnétique est un rayonnement ultraviolet dans une plage de longueurs d'onde comprises entre 100 nm et 400 nm. La durée de l'exposition est comprise entre 1 minute et 60 minutes. La fluence énergétique du rayonnement peut être comprise entre 1 mJ/cm2 et 1 J/cm2. Selon un mode de réalisation, l'étape d'exposition est réalisée en présence d'ozone.

La figure 3 illustre la structure obtenue après l'étape décrite précédemment en relation avec la figure 2. Des groupes hydroxy (-OH) sont fixés au support 12 seulement sur les deuxièmes zones 18 qui ont été exposées au rayonnement électromagnétique.

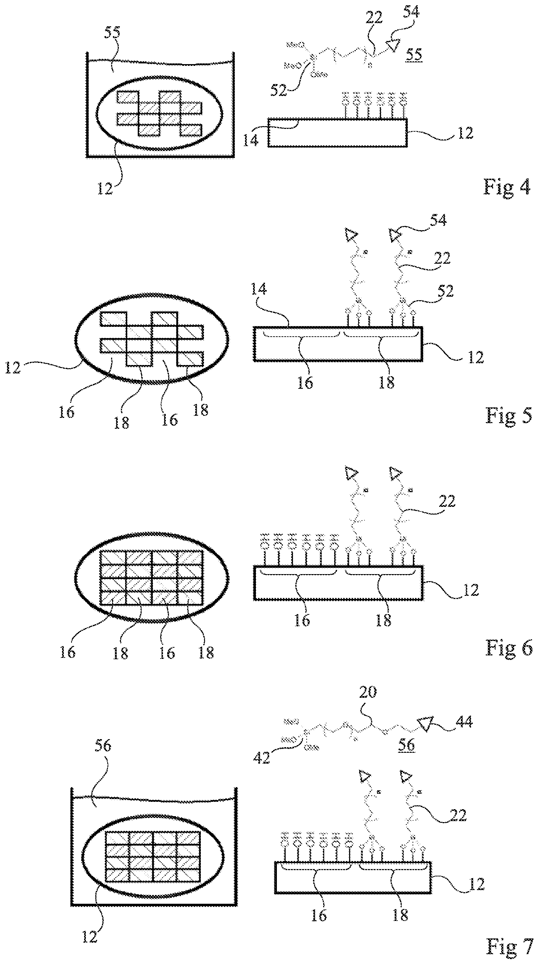

La figure 4 illustre une étape de trempage de la structure représentée en figure 3 dans une solution 55 contenant les premiers ligands hydrophobes 22. La durée de l'étape de trempage peut être comprise entre 30 minutes et 1 mois. Le solvant de la solution 55 peut être un solvant organique aromatique ou aliphatique. Le solvant de la solution 55 peut être choisi dans le groupe comprenant le toluène, le benzène, l'hexane, le pentane et l'éther de pétrole. La concentration des premiers ligands hydrophobes 22 dans la solution peut être supérieure à 10 mM, de préférence entre 40 mM et 1000 mM. L'étape de trempage peut être suivie d'une étape de rinçage du support 12, notamment avec le solvant de la solution 55.

La figure 5 illustre la structure obtenue après l'étape décrite précédemment en relation avec la figure 4. Le troisième groupement 52 de chaque ligand hydrophobe 22 a réagi avec au moins un groupe hydroxy et s'est fixé à la face supérieure 14 du support 12. Les ligands hydrophobes 22 sont ainsi fixés au support 12 seulement sur les deuxièmes zones 18 et ne sont pas présents sur les premières zones 16.

La figure 6 illustre la structure obtenue après une étape d'exposition de la structure représentée en figure 5 à un rayonnement électromagnétique en présence d'un plasma. Les caractéristiques du rayonnement électromagnétique peuvent être celles décrites précédemment à l'étape d'exposition décrite précédemment en relation avec la figure 2. On obtient la fixation de groupes hydroxy sur les premières zones 16. Les ligands hydrophobes 22 ne sont pas modifiés à cette étape. De façon avantageuse, l'étape d'exposition peut être réalisée sans masque.

La figure 7 illustre une étape de trempage de la structure représentée en figure 6 dans une solution 56 contenant le premier ligand hydrophile 20. La durée de l'étape de trempage peut être comprise entre 30 minutes et 1 mois. Le solvant de la solution 56 peut être n'importe quel solvant hydrophile ou amphiphile. Le solvant de la solution 56 peut être choisi dans le groupe comprenant les alcools, notamment l'éthanol ou le méthanol, l'acétate de l'éther monométhylique du propylène glycol (PGMEA), l'acétate d'éthyle, le diméthylformamide (DMF), le diméthylsulfoxyde (DMSO) et l'eau. La concentration du premier ligand hydrophile 20 dans la solution peut être supérieure à 10 mM, de préférence entre 40 mM et 1000 mM. L'étape de trempage peut être suivie d'une étape de rinçage du support 12, notamment avec le solvant de la solution 56.

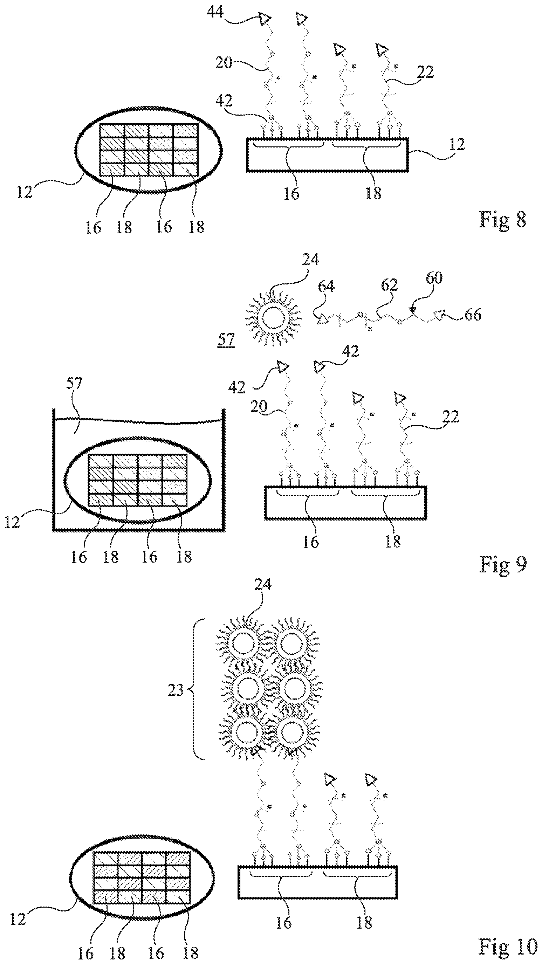

La figure 8 illustre la structure obtenue après l'étape décrite précédemment en relation avec la figure 7. Le premier groupement 42 de chaque ligand hydrophile 20 a réagi avec au moins un groupe hydroxy et s'est fixé à la face supérieure 14 du support 12. Les ligands hydrophiles 20 sont ainsi fixés au support 12 seulement sur les premières zones 16 et ne sont pas présents sur les deuxièmes zones 18. A fortiori, les ligands hydrophiles 20 sont chassés des deuxièmes zones 18 en raison du caractère hydrophobe de ces zones 18. Il est ainsi obtenu un support 12 qui est hydrophile au niveau de chaque première zone 16 et qui est hydrophobe au niveau de chaque deuxième zone 18. De préférence, l'angle de contact d'une solution liquide sur chaque première zone est supérieur d'au moins 40° à l'angle de contact de la même solution liquide sur chaque deuxième zone 18. Un avantage du présent procédé est que les ligands sont stables de sorte que la structure représentée en figure 8 peut être stockée avant la poursuite du procédé sans dégradation du caractère hydrophile des premières zones 16 et du caractère hydrophobe des deuxièmes zones 18.

La figure 9 illustre une étape de trempage de la structure obtenue en figure 8 dans une solution 57 contenant les premières particules photoluminescentes 24. Les premières particules photoluminescentes 24 se fixent aux premiers groupements 42 des premiers ligands hydrophiles 20 de façon à former une monocouche de premières particules photoluminescentes 24. Les premières particules hydrophiles sont en outre chassées des deuxièmes zones 18 en raison du caractère hydrophobe de ces zones 18. La structure obtenue peut être retirée de la solution 57. L'étape de trempage peut être suivie d'une étape de rinçage du support 12, notamment avec le solvant de la solution 57 pour retirer les premières particules photoluminescentes 24 en dehors des premières zones 16. La durée de l'étape de trempage peut être supérieure à 10 secondes, de préférence comprise entre 30 secondes et 5 minutes. Le solvant de la solution 57 peut être choisi dans le groupe comprenant les alcools, notamment l'éthanol ou le méthanol, l'acétate de l'éther monométhylique du propylène glycol (PGMEA), l'acétate d'éthyle, le diméthylformamide (DMF), le diméthylsulfoxyde (DMSO) et l'eau. La concentration des premières particules photoluminescentes 24 dans la solution 57 peut être supérieure à 10 mM, de préférence entre 10 mM et 1000 mM.

S'il est souhaitable d'obtenir un bloc photoluminescent 23 comprenant un empilement de plusieurs couches de premières particules photoluminescentes 24, la structure peut alors être trempée dans une solution contenant les deuxièmes ligands hydrophiles 60. La structure obtenue peut alors être rincée dans le solvant de la solution contenant les deuxièmes ligands hydrophiles 60 pour retirer tous les ligands 60 présents en dehors des premières zones 16. La structure obtenue peut alors être trempée à nouveau dans la solution 57 contenant les premières particules photoluminescentes 24 pour obtenir la formation d'une nouvelle monocouche de premières particules photoluminescentes 24 sur la couche de premières particules photoluminescentes 24 déjà présente. La structure obtenue peut alors être rincée dans le solvant de la solution contenant les premières particules photoluminescentes 24 pour retirer toutes les premières particules photoluminescentes 24 présentes en dehors des premières zones 16. L'opération de trempage dans la solution comprenant les deuxièmes ligands hydrophiles 60 et de trempage dans la solution 57 contenant les premières particules photoluminescentes 24 est répétée autant de fois que nécessaire pour obtenir le nombre souhaité de couches formant le bloc photoluminescent 23.

La figure 10 représente la structure obtenue dans le cas où chaque bloc photoluminescent 23 comprend un empilement de trois monocouches de premières particules photoluminescentes 24, les deuxièmes ligands hydrophiles 60 n'étant pas représentés en figure 10.

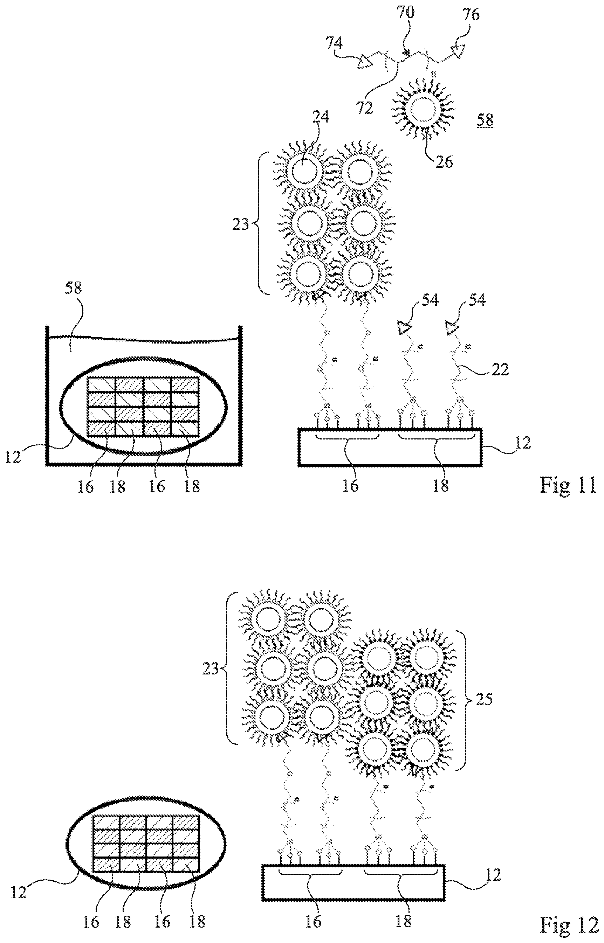

La figure 11 illustre une étape de trempage de la structure obtenue en figure 10 dans une solution 58 contenant les deuxièmes particules photoluminescentes 26. Les deuxièmes particules photoluminescentes 26 se fixent aux quatrièmes groupements 54 des premiers ligands hydrophobes 22 de façon à former une monocouche de deuxièmes particules photoluminescentes 26. La structure obtenue peut être retirée de la solution 58. L'étape de trempage peut être suivie d'une étape de rinçage du support 12, notamment avec le solvant de la solution 58 pour retirer les deuxièmes particules photoluminescentes 26 en dehors des deuxièmes zones 18. La durée de l'étape de trempage peut être supérieure à 10 secondes, de préférence comprise entre 30 secondes et 5 minutes. Le solvant de la solution 58 peut être un solvant organique aromatique ou aliphatique. Le solvant de la solution 58 peut être choisi dans le groupe comprenant le toluène, le benzène, l'hexane, le pentane et l'éther de pétrole. La concentration des deuxièmes particules photoluminescentes 26 dans la solution 58 peut être supérieure à 10 mM, de préférence entre 10 mM et 1000 mM.

S'il est souhaitable d'obtenir un bloc photoluminescent 25 comprenant un empilement de plusieurs couches de deuxièmes particules photoluminescentes 26, la structure peut être trempée dans une solution contenant les deuxièmes ligands hydrophobes 70. La structure obtenue peut alors être rincée dans le solvant de la solution contenant les deuxièmes ligands hydrophobes 70 pour retirer tous les ligands 70 présents en dehors des deuxièmes zones 18. La structure obtenue peut alors être trempée à nouveau dans la solution 58 contenant les deuxièmes particules photoluminescentes 26 pour obtenir la formation d'une nouvelle monocouche de deuxièmes particules photoluminescentes 26 sur la couche de deuxièmes particules photoluminescentes 26 déjà présente. La structure obtenue peut alors être rincée dans le solvant de la solution 58 contenant les deuxièmes particules photoluminescentes 26 pour retirer toutes les deuxièmes particules photoluminescentes 26 présentes en dehors des deuxièmes zones 18. L'opération de trempage dans la solution comprenant les deuxièmes ligands hydrophobes 70 et de trempage dans la solution 58 contenant les deuxièmes particules photoluminescentes 26 est répétée autant de fois que nécessaire pour obtenir le nombre souhaité de couches formant le bloc photoluminescent 25.

La figure 12 représente la structure obtenue dans le cas où le bloc photoluminescent 25 comprend un empilement de trois monocouches de deuxièmes particules photoluminescentes 26, les deuxièmes ligands hydrophobes 70 n'étant pas représentés en figure 12.

Selon un autre mode de réalisation, les étapes décrites précédemment en relation avec les figures 2 à 5 peuvent être mises en oeuvre après les étapes décrites précédemment en relation avec les figures 6 à 8. En effet, les ligands 20 et 22 sont conçus pour n'interagir qu'avec les zones 16 ou 18 qui ont été préalablement activées, c'est-à-dire pour lesquelles des groupes hydroxy sont présents. Cependant, il peut être avantageux d'utiliser la différence de tension de surface pour faciliter la mise en oeuvre du procédé. Si le support 12 est initialement hydrophobe, il peut être avantageux de commencer avec la fixation des ligands hydrophiles 20. En effet, les solutions de ligands 20 et de premières particules 24 sont confinées aux surfaces 16 fonctionnalisées hydrophiles, ce qui permet d'exacerber le caractère hydrophile de ces zones 16 et par conséquent de faciliter la fixation des ligands hydrophobes 22 par la suite. De la même manière, si le wafer est initialement hydrophile, il peut être plus facile de commencer avec la fixation des ligands hydrophobes 22.

A titre de variante de chaque étape de trempage décrite précédemment en relation avec les figures 4, 7, 9 et 11, les ligands hydrophobes 22, les ligands hydrophiles 20, les premières particules photoluminescentes 24 et/ou les deuxièmes particules photoluminescentes 26 peuvent être amenées au contact de la structure obtenue en figure 3, en particulier déposées sur la structure obtenue en figure 3, par exemple par impression par jet d'encre, héliographie, sérigraphie, flexographie, revêtement par pulvérisation (en anglais spray coating), dépôt de gouttes (en anglais drop-casting), par dépôt à la tournette, par héliographie, ou par revêtement à la lame (en anglais blade-coating).

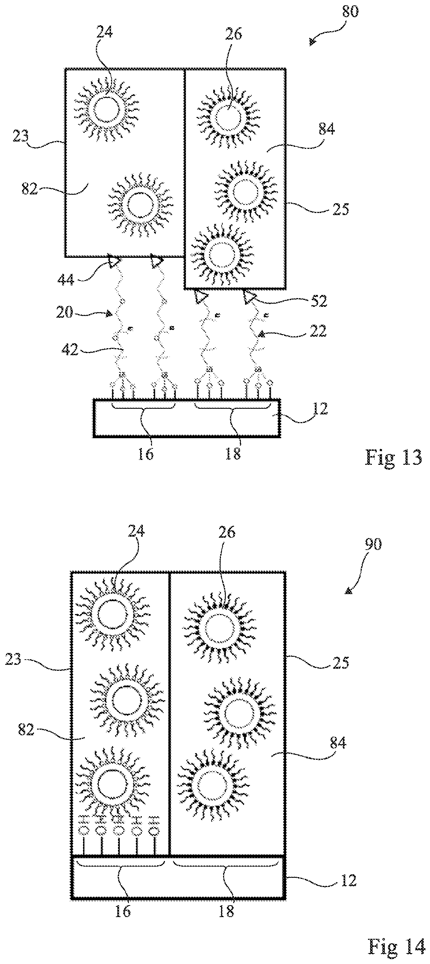

La figure 13 est une vue en coupe, partielle et schématique, d'un autre mode de réalisation d'un dispositif optoélectronique 80. Le dispositif optoélectronique 80 comprend l'ensemble des éléments du dispositif optoélectronique 10 représenté en figure 1 à la différence que le bloc photoluminescent 23 comprend une première matrice 82 dans laquelle sont dispersées les premières particules photoluminescentes 24 et que le bloc photoluminescent 25 comprend une deuxième matrice 84 dans laquelle sont dispersées les deuxièmes particules photoluminescentes 26.

La première ou deuxième matrice 82, 84 est en un matériau au moins en partie transparent au rayonnement émis par les diodes électroluminescentes et aux rayonnements émis par les premières et deuxièmes particules photoluminescentes 24, 26. Selon un mode de réalisation, la première et/ou deuxième matrice 82, 84 est à base acrylate, PMMA, silicone, siloxane ou époxy. La première matrice 82 peut être en un matériau hydrophile et la deuxième matrice 84 peut être en un matériau hydrophobe. Selon un mode de réalisation, chaque premier bloc 23 contient de 2 % à 90 %, de préférence de 10 % à 60 %, en poids de premières particules photoluminescentes 24, par exemple environ 30 % en poids de premières particules photoluminescentes 24. Selon un mode de réalisation, chaque deuxième bloc 25 contient de 2 % à 90 %, de préférence de 10 % à 60 %, en poids de deuxièmes particules photoluminescentes 26, par exemple environ 30 % en poids de deuxièmes particules photoluminescentes 26. Chaque premier ou deuxième bloc 23, 25 peut en outre comprendre des particules de TiO₂.

Un mode de réalisation d'un procédé de fabrication du dispositif optoélectronique 80 représenté en figure 13 comprend l'ensemble des étapes du mode de réalisation du procédé de fabrication du dispositif optoélectronique 10 représenté en figure 1, décrites précédemment en relation avec les figures 2 à 12, à la différence que, à l'étape de trempage décrite précédemment en relation avec la figure 9, la structure représentée en figure 8 est trempée dans une solution contenant des précurseurs de la première matrice 82 et les premières particules photoluminescentes 24 et que, à l'étape de trempage décrite précédemment en relation avec la figure 11, la structure représentée en figure 10 est trempée dans une solution contenant des précurseurs de la deuxième matrice 84 et les deuxièmes particules photoluminescentes 26.

A l'étape de trempage de la structure représentée en figure 8 dans la solution contenant les précurseurs de la première matrice 82 et les premières particules photoluminescentes 24, lorsque la structure est retirée du bain de trempe, la solution ne demeure que sur les premières zones 16 étant donné le caractère hydrophobe des deuxièmes zones 18. L'étape de trempage est suivie d'une étape de séchage ou de réticulation qui conduit à la formation de la première matrice 82 piégeant les premières particules photoluminescentes 24 et ainsi à la formation des premiers blocs photoluminescents 23.

A l'étape de trempage de la structure représentée en figure 11 dans la solution contenant les précurseurs de la deuxième matrice 84 et les deuxièmes particules photoluminescentes 26, lorsque la structure est retirée du bain de trempe, la solution ne demeure que sur les deuxièmes zones 18 en raison du caractère hydrophile des premières zones 16. L'étape de trempage est suivie d'une étape de séchage ou de réticulation qui conduit à la formation de la deuxième matrice 84 piégeant les deuxièmes particules photoluminescentes 26 et ainsi à la formation des deuxièmes blocs photoluminescents 25.

Selon un mode de réalisation, les première et deuxième matrices 82, 84 sont dans la même famille générale de matériau, par exemple les acrylates. Toutefois, la matrice 82 et/ou la matrice 84 sont modifiées pour donner un caractère hydrophile à la matrice 82 et un caractère hydrophobe à la matrice 84. A titre d'exemple, lorsque les matrices 82, 84 sont basées sur des acrylates, la matrice 82 peut être modifiée avec l'ajout de fonctions hydroxyles ou carboxylates pour lui donner un caractère hydrophile.

La figure 14 est une vue en coupe, partielle et schématique, d'un autre mode de réalisation d'un dispositif optoélectronique 90. Le dispositif optoélectronique 90 comprend l'ensemble des éléments du dispositif optoélectronique 80 représenté en figure 13 à la différence que les premiers ligands hydrophiles 20 et les premiers ligands hydrophobes 22 ne sont pas présents, que les premières zones hydrophiles 16 comprennent en surface des groupes hydroxy -OH, et que les blocs photoluminescents 23, 25 sont au contact du support 12. En outre, dans le présent mode de réalisation, le support 12 est en un matériau hydrophobe de sorte que les deuxièmes zones 18 sont hydrophobes sans prévoir un traitement particulier pour rendre les deuxièmes zones 18 hydrophobes. A titre de variante, les zones hydrophiles 16 peuvent correspondre à une couche recouvrant le support 12, en un matériau différent du matériau composant le support 12, et ayant une énergie de surface différente de celle du support 12 de sorte que l'angle de contact statique d'une solution liquide sur les zones hydrophiles 16 est supérieur à l'angle de contact statique de la solution liquide sur le support 12 d'au moins 30 degrés, de préférence d'au moins 40 degrés, plus préférentiellement d'au moins 50 degrés.

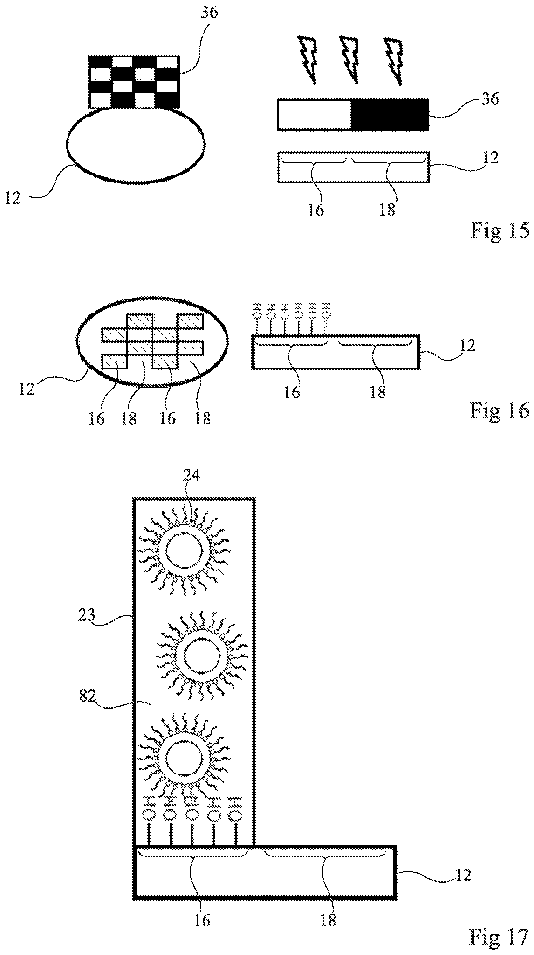

Les figures 15 à 17 représentent chacune, en partie gauche, une vue en perspective, partielle et schématique, du dispositif optoélectronique, et, en partie droite, une vue en coupe partielle du dispositif de la partie gauche, à des étapes successives d'un mode de réalisation du procédé de fabrication du dispositif optoélectronique 90 représenté en figure 14.

La figure 15 illustre une étape d'exposition du support 12 analogue à l'étape décrite précédemment en relation avec la figure 2 à la différence que ce sont les premières zones 16 qui sont exposées au rayonnement en présence d'un plasma d'ozone.

La figure 16 illustre la structure obtenue après l'étape décrite précédemment en relation avec la figure 15. Des groupes hydroxy (-OH) sont fixés au support 12 seulement sur les premières zones 16 qui ont été exposées au rayonnement électromagnétique.

La figure 17 illustre la structure obtenue après une étape de trempage de la structure obtenue en figure 16 dans une solution contenant les précurseurs de la première matrice 82 et les premières particules photoluminescentes 24, et une étape de solidification de la première matrice 82 pour former les premiers blocs photoluminescents 23. A l'étape de trempage, la première matrice 82 hydrophile se place seulement sur les premières zones 16 qui sont hydrophiles en raison des fonctions hydroxy tandis que les deuxièmes zones 18 sont hydrophobes.

Le procédé se poursuit ensuite par une étape de trempage de la structure obtenue en figure 17 dans une solution contenant les précurseurs de la deuxième matrice 84 et les deuxièmes particules photoluminescentes 26, et par une étape de solidification de la deuxième matrice 84 pour former les deuxièmes blocs photoluminescents 25. A l'étape de trempage, la deuxième matrice 84 hydrophobe se place seulement sur les deuxièmes zones 18 qui sont hydrophobes tandis que les premiers blocs photoluminescents 82 sont hydrophiles.

A titre de variante des étapes de trempage décrites précédemment en relation avec la figure 17, la solution contenant la première matrice 82 et les premières particules photoluminescentes 24 et la solution contenant la deuxième matrice 84 et les deuxièmes particules photoluminescentes 26 peuvent être déposées par exemple par impression par jet d'encre, héliographie, sérigraphie, flexographie, revêtement par pulvérisation (en anglais spray coating), dépôt de gouttes (en anglais drop-casting), par dépôt à la tournette, par héliographie, ou par revêtement à la lame (en anglais blade-coating).

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. L'invention étant limitée par les revendications ci après.

## Revendications

1. Dispositif optoélectronique (10 ; 80 ; 90) comprenant un support (12), au moins des blocs photoluminescents hydrophiles (23) comprenant des particules photoluminescentes hydrophiles (24) recouvrant des premières zones (16) du support et des blocs photoluminescents hydrophobes (25) comprenant des particules photoluminescentes hydrophobes (26) recouvrant des deuxièmes zones (18) du support, les blocs photoluminescents hydrophiles étant au contact d'un matériau hydrophile (20) au niveau des premières zones et les blocs photoluminescents hydrophobes étant au contact d'un matériau hydrophobe (22) au niveau des deuxièmes zones.

2. Dispositif selon la revendication 1, dans lequel chaque bloc photoluminescent hydrophile (23) comprend au moins une monocouche desdites particules photoluminescentes hydrophiles (24).

3. Dispositif selon la revendication 1 ou 2, dans lequel chaque bloc photoluminescent hydrophobe (25) comprend au moins une monocouche desdites particules photoluminescentes hydrophobes (26).

4. Dispositif selon la revendication 1, dans lequel chaque bloc photoluminescent hydrophile (23) comprend une matrice hydrophile (82) dans laquelle sont dispersées les particules photoluminescentes hydrophiles (24).

5. Dispositif selon la revendication 1 ou 4, dans lequel chaque bloc photoluminescent hydrophobe (25) comprend une matrice hydrophobe (84) dans laquelle sont dispersées les particules photoluminescentes hydrophobes (26).

6. Dispositif selon l'une quelconque des revendications 1 à 5, dans lequel le matériau hydrophile comprend des premiers ligands hydrophiles (20), comprenant chacun une chaîne hydrophile (40), un premier groupement (42) à une première extrémité de la chaîne hydrophile, fixé à un groupe hydroxy en surface du support (12), et un deuxième groupement (44) à une deuxième extrémité de la chaîne hydrophile, opposée à la première extrémité, au contact de l'un des blocs photoluminescents hydrophiles (23).

7. Dispositif selon la revendication 6, dans lequel les deuxièmes groupements (44) sont fixés à desdites particules photoluminescentes hydrophiles (24).

8. Dispositif selon la revendication 6 ou 7, dans lequel chaque bloc photoluminescent hydrophile (23) comprend un empilement de couches des particules photoluminescentes hydrophiles (24) et des deuxièmes ligands hydrophiles (60) fixés à des particules photoluminescentes hydrophiles de couches différentes.

9. Dispositif selon l'une quelconque des revendications 1 à 8, dans lequel le matériau hydrophobe comprend des premiers ligands hydrophobes (22), comprenant chacun une chaîne hydrophobe (50), un troisième groupement (52) à une troisième extrémité de la chaîne hydrophobe, fixé à un groupe hydroxy en surface du support (12), et un quatrième groupement (54) à une quatrième extrémité de la chaîne hydrophobe au contact de l'un des blocs photoluminescents hydrophobes (25).

10. Dispositif selon la revendication 9, dans lequel les quatrièmes groupements (54) sont fixés à desdites particules photoluminescentes hydrophobes (26).

11. Dispositif selon la revendication 9 ou 10, dans lequel chaque bloc photoluminescent hydrophobe (25) comprend un empilement de couches des particules photoluminescentes hydrophobes (26) et des deuxièmes ligands hydrophobes (70) fixés à des particules photoluminescentes hydrophobes de couches différentes

12. Dispositif selon l'une quelconque des revendications 1 à 11, comprenant des diodes électroluminescentes recouvertes par les blocs photoluminescents hydrophiles et hydrophobes (23, 25).

13. Procédé de fabrication du dispositif optoélectronique (10 ; 80 ; 90) selon l'une quelconque des revendications 1 à 12, comprenant la formation, sur le support (12), au moins des blocs photoluminescents hydrophiles (23) comprenant les particules photoluminescentes hydrophiles (24) recouvrant les premières zones (16) du support et des blocs photoluminescents hydrophobes (25) comprenant les particules photoluminescentes hydrophobes (26) recouvrant les deuxièmes zones (18) du support, les blocs photoluminescents hydrophiles étant au contact du matériau hydrophile (20) au niveau des premières zones et les blocs photoluminescents hydrophobes étant au contact du matériau hydrophobe (22) au niveau des deuxièmes zones.

14. Procédé selon la revendication 13, comprenant pour la formation des blocs photoluminescents hydrophiles et hydrophobes (23, 25) une seule étape d'exposition du support (12) à un rayonnement électromagnétique au travers d'un masque (36).

15. Procédé selon la revendication 13, dans lequel chaque bloc photoluminescent hydrophile (23) comprend une matrice hydrophile (82) dans laquelle sont dispersées les particules photoluminescentes hydrophiles (24), dans lequel chaque bloc photoluminescent hydrophobe (25) comprend une matrice hydrophobe (84) dans laquelle sont dispersées les particules photoluminescentes hydrophobes (26), le procédé comprenant des étapes de formation de groupes hydroxy aux premières zones (16), d'application d'une cinquième solution contenant des précurseurs de la matrice hydrophile (82) et les particules photoluminescentes hydrophiles (24), de formation de la matrice hydrophile dans laquelle sont dispersées les particules photoluminescentes hydrophiles, d'application d'une sixième solution contenant des précurseurs de la matrice hydrophobe (84) et les particules photoluminescentes hydrophobes (26), et de formation de la matrice hydrophobe dans laquelle sont dispersées les particules photoluminescentes hydrophobes.

## Patentansprüche

1. Optoelektronische Vorrichtung (10; 80; 90), die einen Träger (12) aufweist, weiter zumindest hydrophile photolumineszente Blöcke (23), welche hydrophile photolumineszente Partikel (24) aufweisen, die erste Bereiche (16) des Trägers bedecken, und hydrophobe photolumineszente Blöcke (25), welche hydrophobe photolumineszente Partikel (26) aufweisen, die zweite Bereiche (18) des Trägers bedecken, wobei die hydrophilen photolumineszenten Blöcke in Kontakt mit einem hydrophilen Material (20) auf dem Niveau der ersten Bereiche sind, und wobei die hydrophoben photolumineszenten Blöcke in Kontakt mit einem hydrophoben photolumineszenten Blöcke in Kontakt mit einem hydrophoben Material (22) auf dem Niveau der zweiten Bereiche sind.

2. Vorrichtung nach Anspruch 1, wobei jeder hydrophile photolumineszente Block (23) zumindest eine Monoschicht der hydrophilen photolumineszenten Partikel (24) aufweist.

3. Vorrichtung nach Anspruch 1 oder 2, wobei jeder hydrophobe photolumineszente Block (25) zumindest eine Monoschicht der hydrophoben photolumineszenten Partikel (26) aufweist.

4. Vorrichtung nach Anspruch 1, wobei jeder hydrophile photolumineszente Block (23) eine hydrophile Matrix (82) aufweist, in welcher die hydrophilen photolumineszenten Partikel (24) verteilt sind.

5. Vorrichtung nach Anspruch 1 oder 4, wobei jeder hydrophobe photolumineszente Block (25) eine hydrophobe Matrix (84) aufweist, in welcher die hydrophoben photolumineszenten Partikel (26) verteilt sind.

6. Vorrichtung nach einem der Ansprüche 1 bis 5, wobei das hydrophile material erste hydrophile Liganden (20) aufweist, die jeweils eine hydrophile Kette (40) aufweisen, eine erste Gruppe (42) an einem ersten Ende der hydrophilen Kette, und zwar gebunden an eine Hydroxygruppe an der Oberfläche des Trägers (12), und eine zweite Gruppe (44) an einem zweiten Ende der hydrophilen Kette entgegengesetzt zur ersten kette in Kontakt mit einem der hydrophilen photolumineszenten Blöcke (23).

7. Vorrichtung nach Anspruch 6, wobei die zweiten Gruppen (44) an die hydrophilen photolumineszenten Partikeln (24) gebunden sind.

8. Vorrichtung nach Anspruch 6 oder 7, wobei jeder hydrophile photolumineszente Block (23) ein Stapel von Schichten der hydrophilen photolumineszenten Partikel (24) und zweite hydrophile Liganden (60) aufweist, die an die hydrophilen photolumineszenten Partikeln von unterschiedlichen Schichten gebunden sind.

9. Vorrichtung nach einem der Ansprüche 1 bis 8, wobei das hydrophobe Material erste hydrophobe Liganden (22) aufweist, die jeweils eine hydrophobe Kette (50) aufweisen, eine dritte Gruppe (52) an einem dritten Ende der hydrophoben Kette, die an die Hydroxygruppe an der Oberfläche des Trägers (12) gebunden ist, und eine vierte Gruppe (54) an einem vierten Ende der hydrophoben Kette in Kontakt mit einem der hydrophoben photolumineszenten Blöcke (25).

10. Vorrichtung nach Anspruch 9, wobei die vierten Gruppen (54) an die hydrophoben photolumineszenten Partikel (26) gebunden sind.

11. Vorrichtung nach Anspruch 9 oder 10, wobei jeder hydrophobe photolumineszente Block (25) einen Stapel von Schichten der hydrophoben photolumineszenten Partikel (26) und zweite hydrophobe Liganden aufweist, die mit hydrophoben photolumineszenten Partikeln von unterschiedlichen Schichten verbunden sind.

12. Vorrichtung nach einem der Ansprüche 1 bis 11, welche lichtemittierende Dioden aufweist, die mit hydrophilen und hydrophoben photolumineszenten Blöcken (23, 25) bedeckt sind.

13. Verfahren zur Herstellung der optoelektronischen Vorrichtung (10;80; 90) nach einem der Ansprüche 1 bis 12, welches das Formen auf dem Träger (12) von zumindest den hydrophilen photolumineszenten Blöcken (23) aufweist, welche die hydrophilen photolumineszenten Partikel (24) aufweisen, die die ersten Bereiche (16) des Trägers bedecken, und der hydrophoben photolumineszenten Blöcke (25), welche die hydrophoben photolumineszenten Partikel (26) aufweisen, die die zweiten Bereiche (18) des Trägers bedecken, wobei die hydrophilen photolumineszenten Blöcke in Kontakt mit dem hydrophilen Material (20) auf dem Niveau der ersten Bereiche sind, und wobei die hydrophoben photolumineszenten Blöcke in Kontakt mit dem hydrophoben Material (22) auf dem Niveau der zweiten Bereiche sind.

14. Verfahren nach Anspruch 13, welches für das Formen der hydrophilen und hydrophoben photolumineszenten Blöcke (23, 25) einen einzigen Schritt des Belichtens des Trägers (12) mit einer elektromagnetischen Strahlung durch eine Maske (36) aufweist.

15. Verfahren nach Anspruch 13, wobei jeder hydrophile photolumineszente Block (23) eine hydrophile Matrix (82) aufweist, in der die hydrophilen photolumineszenten Partikel (24) verteilt sind, wobei jeder hydrophobe photolumineszente Block (25) eine hydrophobe Matrix (84) aufweist, in der die hydrophoben photolumineszenten Partikel (26) verteilt sind, wobei das Verfahren die Schritte aufweist, Hydroxygruppen in dem ersten Bereich (16) zu formen, eine fünfte Lösung aufzubringen, welche Präkursoren der hydrophilen Matrix (82) und der hydrophilen photolumineszenten Partikel (24) enthält, die hydrophile Matrix, in welcher die hydrophilen photolumineszenten Partikel verteilt sind, zu formen, eine sechste Lösung aufzubringen welche Präkursoren der hydrophoben Matrix (84) und der hydrophoben photolumineszenten Partikel (26) enthält, und die hydrophobe Matrix zu formen, in welcher die hydrophoben photolumineszenten Partikel verteilt sind.

## Claims

1. An optoelectronic device (10; 80; 90) comprising a support (12), at least hydrophilic photoluminescent blocks (23) comprising hydrophilic photoluminescent particles (24) covering first areas (16) of the support and hydrophobic photoluminescent blocks (25) comprising hydrophobic photoluminescent particles (26) covering second areas (18) of the support, the hydrophilic photoluminescent blocks being in contact with a hydrophilic material (20) at the level of the first areas and the hydrophobic photoluminescent blocks being in contact with a hydrophobic material (22) at the level of the second areas.

2. The device of claim 1, wherein each hydrophilic photoluminescent block (23) comprises at least one monolayer of said hydrophilic photoluminescent particles (24) .

3. The device of claim 1 or 2, wherein each hydrophobic photoluminescent block (25) comprises at least one monolayer of said hydrophobic photoluminescent particles (26) .

4. The device of claim 1, wherein each hydrophilic photoluminescent block (23) comprises a hydrophilic matrix (82) having the hydrophilic photoluminescent particles (24) dispersed therein.

5. The device of claim 1 or 4, wherein each hydrophobic photoluminescent block (25) comprises a hydrophobic matrix (84) having the hydrophobic photoluminescent particles (26) dispersed therein.

6. The device of any of claims 1 to 5, wherein the hydrophilic material comprises first hydrophilic ligands (20), each comprising a hydrophilic chain (40), a first group (42) at a first end of the hydrophilic chain, bonded to a hydroxy group at the surface of the support (12), and a second group (44) at a second end of the hydrophilic chain, opposite to the first end, in contact with one of the hydrophilic photoluminescent blocks (23).

7. The device of claim 6, wherein the second groups (44) are bonded to said hydrophilic photoluminescent particles (24) .

8. The device of claim 6 or 7, wherein each hydrophilic photoluminescent block (23) comprises a stack of layers of the hydrophilic photoluminescent particles (24) and second hydrophilic ligands (60) bonded to hydrophilic photoluminescent particles of different layers.

9. The device of any of claims 1 to 8, wherein the hydrophobic material comprises first hydrophobic ligands (22), each comprising a hydrophobic chain (50), a third group (52) at a third end of the hydrophobic chain, bonded to a hydroxy group at the surface of the support (12), and a fourth group (54) at a fourth end of the hydrophobic chain in contact with one of the hydrophobic photoluminescent blocks (25).

10. The device of claim 9, wherein the fourth groups (54) are bonded to said hydrophobic photoluminescent particles (26) .

11. The device of claim 9 or 10, wherein each hydrophobic photoluminescent block (25) comprises a stack of layers of the hydrophobic photoluminescent particles (26) and second hydrophobic ligands (70) bonded to hydrophobic photoluminescent particles of different layers.

12. The device of any of claims 1 to 11, comprising light-emitting diodes covered with hydrophilic and hydrophobic photoluminescent blocks (23, 25).

13. A method of manufacturing the optoelectronic device (10; 80; 90) of any of claims 1 to 12, comprising the forming, on the support (12), of at least the hydrophilic photoluminescent blocks (23) comprising the hydrophilic photoluminescent particles (24) covering the first areas (16) of the support and of the hydrophobic photoluminescent blocks (25) comprising the hydrophobic photoluminescent particles (26) covering the second areas (18) of the support, the hydrophilic photoluminescent blocks being in contact with the hydrophilic material (20) at the level of the first areas and the hydrophobic photoluminescent blocks being in contact with the hydrophobic material (22) at the level of the second areas.

14. The method of claim 13, comprising, for the forming of the hydrophilic and hydrophobic photoluminescent blocks (23, 25), a single step of exposure of the support (12) to an electromagnetic radiation through a mask (36).

15. The method of claim 13, wherein each hydrophilic photoluminescent block (23) comprises a hydrophilic matrix (82) having the hydrophilic photoluminescent particles (24) dispersed therein, wherein each hydrophobic photoluminescent block (25) comprises a hydrophobic matrix (84) having the hydrophobic photoluminescent particles (26) dispersed therein, the method comprising steps of forming hydroxy groups in the first areas (16), of applying a fifth solution containing precursors of the hydrophilic matrix (82) and the hydrophilic photoluminescent particles (24), of forming the hydrophilic matrix having the hydrophilic photoluminescent particles dispersed therein, of applying a sixth solution containing precursors of the hydrophobic matrix (84) and the hydrophobic photoluminescent particles (26), and of forming the hydrophobic matrix having the hydrophobic photoluminescent particles dispersed therein.
